# EUROPEAN PATENT APPLICATION

(11) **EP 4 815 700 A1**
(43) Date of publication of application: **30.09.2026**
(21) Application number: 26167159.8
(22) Date of filing: 24.03.2026
(51) Int. Cl.: H10N 52/00, H10N 52/01, H10N 52/85, H10N 99/00

(54) **METHOD FOR MANUFACTURING NANODEVICE BASED ON SINGLE-CRYSTALLINE COPPER (CU) THIN FILM AND NANODEVICE HAVING BALLISTIC TRANSPORT CHARACTERISTICS**

(30) Priority: 24.03.2025 KR 20250037320; 02.07.2025 KR 20250088515
(71) Applicant: Pusan National University Industry-University Cooperation Foundation, Busan 46241 (KR); POSTECH Research and Business Development Foundation, Pohang-si, Gyeongsangbuk-do 37673 (KR)
(72) Inventor: Jeong, Se Young, 46241 Busan (KR); Lee, Gilho, 37673 Pohang-si, Gyeongsangbuk-do (KR); Cho, Yongjin, 37673 Pohang-si, Gyeongsangbuk-do (KR)
(74) Representative: Gulde & Partner

(57) **Abstract**

The present application relates to nano-electronic device technology, and more specifically, to a nanodevice manufactured based on a single-crystalline copper (Cu) thin film and a method for manufacturing the same, wherein the device includes a structure capable of suppressing electron scattering and realizing ballistic transport characteristics.

A nanodevice having ballistic transport characteristics according to the present application includes a single-crystalline metal thin film with removed grain boundaries, wherein the single-crystalline metal thin film is formed to suppress electron scattering, and includes conduction paths formed to have a nanometer width through electron beam lithography and an ion etching process, and the conduction path exhibits an electrical response, in which negative bend resistance occurs when electrons are transported at a low temperature.

## Description

### BACKGROUND OF THE INVENTION

### Field of the Invention

The present invention relates to nano-electronic device technology, and more specifically, to a nanodevice manufactured based on a single-crystalline copper (Cu) thin film and a method for manufacturing the same, wherein the device includes a structure capable of suppressing electron scattering and realizing ballistic transport characteristics.

### Background of the Related Art

When the mean free path of electrons is longer than the device size, the electrons show ballistic transport without being greatly affected by scattering by phonons, rough surfaces, impurities, crystal defects (e.g., grain boundaries, GBs), and the like. Here, the grain boundary is the boundary between two adjacent grains having different crystal orientations. Since quantum information such as crystal momentum, spin, and quantum phase of electron are well preserved, the ballistic transport is used as a means for revealing intrinsic quantum characteristics of solid materials.

Over the past several decades, studies on quantum characteristics of general metals, such as the electronic band structure, Fermi surface topology, electrical conductivity, and magnetic resistance, have been actively conducted. Among these metals, copper (Cu) has a long history of use in electronic circuits owing to excellent conductivity, reliability, and versatility, and is widely utilized for high-speed data cables and interconnect of advanced semiconductor devices. The electronic band structure, Fermi surface topology, and Fermi velocity of bulk Cu are well understood through the de Haas-van Alphen effect, galvanomagnetic phenomenon, photoemission, cyclotron resonance, abnormal skin effect, and magneto-acoustic resonance measurement.

However, growing atomically uniform and flat Cu thin films without crystal defects, such as grain boundaries, is very challenging technically, and ballistic transport in a Cu thin-film-based nanostructure has not yet been achieved. This is a significant limitation in experimentally utilizing intrinsic quantum characteristics of the copper.

The present invention reports that ballistic transport is experimentally observed in nanodevices manufactured on the basis of an atomically flat single-crystalline Cu(111) thin film (SCCF). The film is grown using an atomic sputtering epitaxy (ASE) technique that may overcome the limitations of conventional metal thin film deposition, and solve the problems of electromigration due to surface oxidation, electrical performance degradation, and crystal defects (GBs, impurities, etc.).

The present invention has observed negative bend resistance in a device of a crossbar structure, and this is interpreted as the characteristic of ballistic transport. The mean free path of electrons is estimated to be approximately 150 nm below 85 K in a SCCF of an approximately 90 nm thickness. The SCCF may be utilized in the study of quantum characteristics of the Cu thin film, including quantum Hall effect, quantum confinement effect, topological characteristics, hydrodynamic electron transport, phase-coherent quantum interference, and the like, and this may be extended to studies on other metal thin films. In addition, it suggests practical applicability in quantum circuits, spintronic devices, and copper interconnect technologies.

### SUMMARY OF THE INVENTION

Therefore, the present invention has been made in view of the above problems, and it is an object of the present invention to provide a nanodevice which can realize ballistic transport characteristics in a low temperature environment and a method for manufacturing the same by implementing a structure capable of minimizing electron scattering and preserving the phase of electrons using a high-quality single-crystalline copper (Cu) thin film with removed grain boundaries.

In addition, another object of the present invention is to establish a technical basis that is advantageous for application of quantum devices and high-speed electronic devices in the future by providing a structure capable of high-precision patterning through a process of electron beam lithography and argon ion milling.

The technical problems to be solved by the invention are not limited to the technical problems mentioned above, and unmentioned other technical problems can be clearly understood by those skilled in the art from the following descriptions.

To accomplish the above objects, according to one aspect of the present invention, there is provided a nanodevice having ballistic transport characteristics, the nanodevice including a single-crystalline metal thin film with removed grain boundaries, wherein the single-crystalline metal thin film is formed to suppress electron scattering, and includes conduction paths formed to have a nanometer width through electron beam lithography and an ion etching process, and the conduction path exhibits an electrical response, in which negative bend resistance occurs when electrons are transported at a low temperature.

In addition, according to another aspect of the present invention, there is provided a method for manufacturing a nanodevice based on a single-crystalline copper (Cu) thin film, the method comprising the steps of: forming a single-crystalline copper thin film with removed grain boundaries, aligned in a (111) crystal plane direction on a sapphire (Al₂O₃) substrate, using an atomic sputtering epitaxy (ASE) method; forming a nanometer-wide pattern by performing electron beam lithography on the single-crystalline copper thin film; forming a conduction path by performing argon (Ar) ion etching on the basis of the pattern; completing the nanodevice by forming electrodes at both ends of the conduction path; and confirming whether an electrical response, in which negative bend resistance occurs when electrons are transported, is exhibited through the conduction path.

### BRIEF DESCRIPTION OF THE DRAWINGS

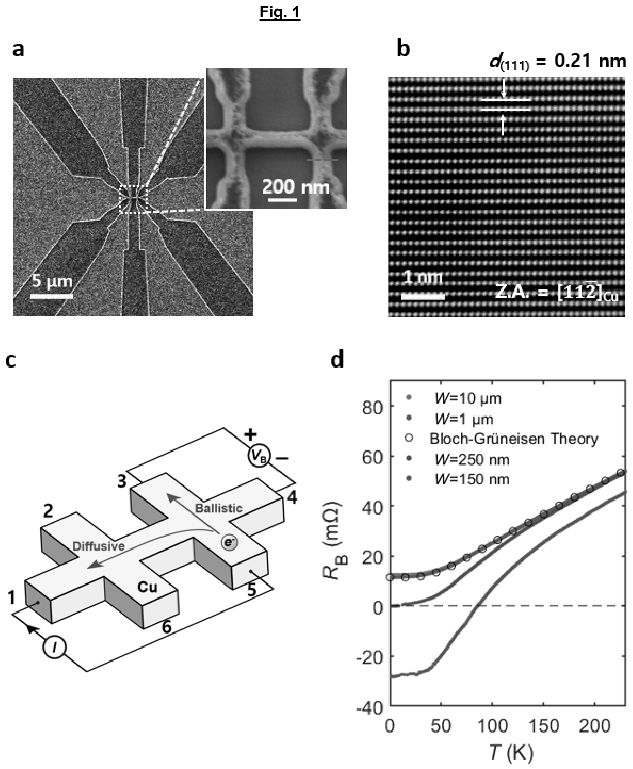

FIG. 1 is a view showing ballistic transport images of a single-crystalline Cu(111) thin film according to an embodiment of the present invention. (a) shows a scanning electron microscope (SEM) image of a Hall bar device having a channel width of W=150 nm, and the inserted image is an enlarged image of the indicated area. (b) shows a cross-sectional TEM image obtained by cutting with a focused ion beam (FIB). (c) is a view showing measurements of bend resistance R_{B}, in which electron trajectories of diffusive transport and ballistic transport are indicated as blue and red arrows, respectively. (d) shows dependency of R_{B} on the temperature in the devices of W=10 µm, 1 µm, 250 nm, and 150 nm, and the circular symbols are results of fitting using a Bloch-Gruneisen function.

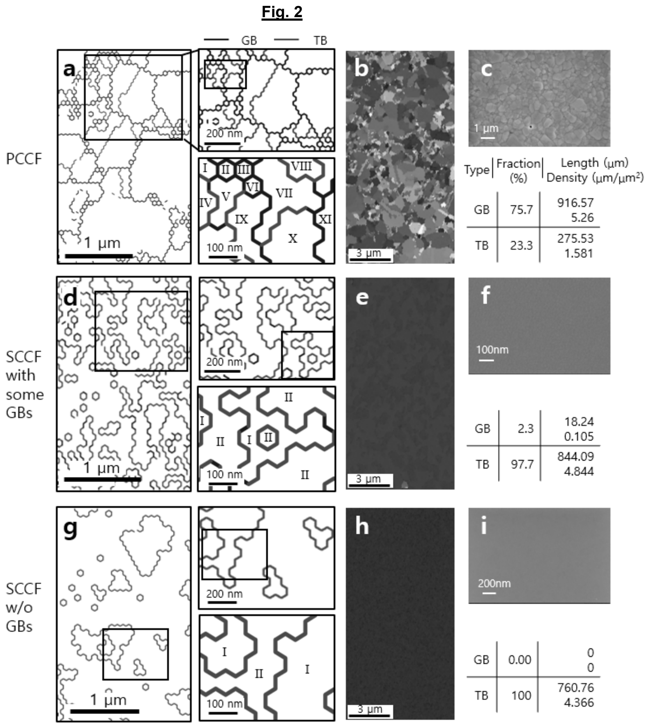

FIG. 2 is a view showing grain boundaries (GBs) and twin boundaries (TBs) in a PCCF and a SCCF according to an embodiment of the present invention, and (a) shows a map and an enlarged image showing the difference in crystal orientation of the PCCF, in which GBs and TBs are indicated as blue and red lines, respectively. (b) shows an electron backscatter diffraction (EBSD) map of the PCCF, showing random alignment. (c) shows a SEM image of the PCCF, in which a rough surface and GBs can be confirmed. (d to i) show microstructure analysis images of an SCCF with reduced GBs and an SCCF with completely removed GBs.

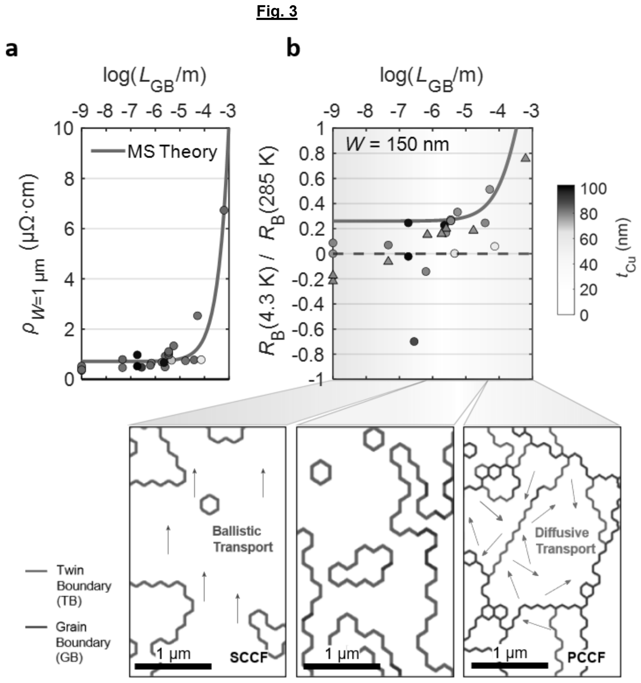

FIG. 3 is a view showing an electrical transport image with respect to GB length according to an embodiment of the present invention, and (a) shows the relationship between terminal resistance measured at 4.3 K in a device of W=1 µm and GB length L_{GB}. (b) shows the relationship between normalized bend resistance R_{B} and L_{GB} in a device of W=150 nm.

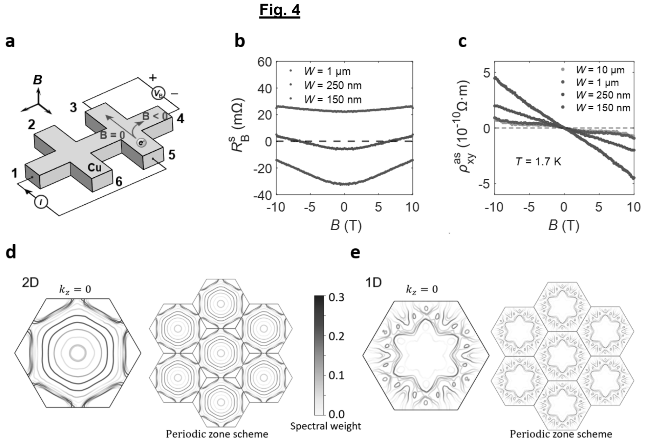

FIG. 4 is a view showing bend resistance and geometric effects according to the magnetic field according to an embodiment of the present invention, and (a) is a view showing measurements of symmetrized bend resistances R_{B}^{s} in the magnetic field. (b) is an image showing dependency of bend resistance R_{B}^{s} on the magnetic field (B) in the devices of W=1 µm, 250 nm, and 150 nm. (c) is a view showing measurements of asymmetric Hall resistance ρ_{xy} measured at 1.7 K in SCCF devices of various W. (d to e) show a Fermi surface calculated in Cu(111) of 2D and 1D structures.

### DETAILED DESCRIPTION OF THE PREFERRED EMBODIMENT

The terms used in this specification will be briefly described, and the present invention will be described in detail.

Although general terms that are widely used in the present are selected as the terms used in the present invention as much as possible taking into account their functions, this may be changed according to the intention of those skilled in the art, precedents, emergence of new technologies, or the like. Accordingly, the terms used in the present invention should be defined based on the meaning of the terms and the overall content of the present invention, rather than simply based on their names.

When a part is said to include a certain component throughout the specification, this means that it may further include other components, rather than excluding the components, unless specifically stated otherwise.

Hereinafter, embodiments of the present invention will be described in detail with reference to the accompanying drawings so that those skilled in the art may implement with ease. However, the present invention may be implemented in various different forms and is not limited to the embodiments described herein.

Details of the present invention, including the problems to be solved, the means for solving the problems, and the effects of the invention, are included in the embodiments and drawings described below. The advantages and features of the present invention and methods for achieving them will become clear with reference to the embodiments described below in detail, together with the accompanying drawings.

Hereinafter, the present invention will be described in more detail with reference to the accompanying drawings.

The present invention relates to a nano-electronic device that utilizes the ballistic transport phenomenon of electrons, and the basic concepts and conditions of electron transport will be described to understand this concept.

Ballistic transport means an electron transport method, in which electrons are conducted through a nearly straight path without scattering by grain boundaries, impurities, lattice vibrations (phonons), and the like when the electrons move within a solid material. In the ballistic transport like this, the momentum, phase information, and quantum state of electrons are preserved (coherent) without being disturbed by the outside, and this is fundamentally distinguished from general diffusive transport.

Although the electron-phonon interaction may still exist, this does not necessarily mean inelastic scattering, which leads to loss of energy or momentum. In particular, in a low temperature environment, in which the number of phonons decreases, the probability of scattering due to the interaction is significantly reduced, and electrons may move a long distance while maintaining the quantum coherence state. Owing to this, phenomena such as quantum interference, coherent oscillation, and the like are generated, and this acts as a core physical basis in designing high-speed electronic devices and quantum computing devices.

For occurrence of ballistic transport, conditions described below should be satisfied.

First, a low temperature environment is required. The lower the temperature, the number of phonons within the crystal decreases, and this greatly reduces the possibility of scattering the electrons. In the embodiment of the present invention, the ballistic transport characteristic like this is stably observed in an environment of approximately 85 K or lower.

Second, a single-crystalline structure of high crystallinity is required. In particular, in the present invention, a single-crystalline copper (Cu) thin film aligned in the (111) plane direction is formed using an atomic sputtering epitaxy (ASE) process, and this thin film maximizes the mean free path of electrons as the grain boundaries are removed practically.

Third, implementation of a nanostructured conduction path is required. The narrower the moving path of the electrons and the clearer the boundaries, the higher the probability of incident electrons to reach the exit without scattering, and this facilitates implementation of ballistic transport. In the present invention, a nanostructured conduction path having a channel width of approximately 150 nm or smaller is implemented through lithography and an ion etching process.

When an environment in which electrons may move without energy loss and scattering is created, the device shows an electrical response such as negative bend resistance. This is a phenomenon occurring when electrons are directly transferred between electrodes, and this is used as a core measurement index of the present invention.

In summary, as the present invention realizes a ballistic transport mechanism in which the quantum state and phase of electrons are preserved, it can be applied to various high-functional semiconductor systems such as low-loss signal transmission circuits, quantum devices, high-speed nano-electronic devices, and the like based on electromagnetic interference. In particular, the nano-conduction structure based on the single-crystalline copper thin film implemented in the present invention effectively suppresses the problems of electron scattering and heat generation that occur in conventional polycrystalline metal structures, and provides a technical basis highly suitable for interconnect between metals of semiconductor packages and quantum circuits operating at a low temperature.

The nanodevice based on the single-crystalline copper thin film of the present invention may be applied to a metal wiring (interconnect) structure inside a semiconductor chip that should minimize loss of high-speed electronic signals.

In particular, as the single-crystalline copper (Cu) (111) thin film, in which electron scattering is suppressed as the grain boundaries are removed, and the conduction path of nanometer wide secure a mean free path of a level capable of ballistic transport, loss of resistance and generation of heat can be minimized.

In addition, as the nanodevice of the present invention has a characteristic of stable electronic interference in a low temperature environment, it may also be applied as a conduction channel in a quantum device or a spintronic device based on quantum interference.

For example, the structure of the present invention, in which negative bend resistance is observed in an environment of 85 K or lower, may be used as an electron transport path, which maintains phase information, in a quantum device circuit that requires operation at a low temperature.

### 1. Nanodevice having ballistic transport characteristics

The present invention relates to a nano-electronic device capable of implementing ballistic transport characteristics on the basis of a single-crystalline metal thin film with removed grain boundaries, particularly a single-crystalline copper (Cu) thin film aligned along the (111) crystal plane, and a method for manufacturing the same. The core concept of the present invention is to form a conduction path having a channel narrower than the mean free path of electrons within a single-crystalline metal thin film so that an environment for moving electrons without scattering is created to exhibit negative bend resistance.

The metal thin film used in the present invention is grown through an atomic sputtering epitaxy (ASE) process to be formed on a sapphire (Al₂O₃) substrate at a thickness of 10 to 90 nm. In the ASE process, grain boundaries are not formed as deposition is accomplished in units of single atoms, and copper atoms are induced to be aligned in the (111) crystal plane direction. The single-crystalline copper thin film grown in this way includes only twin boundaries, and may secure high crystallinity as grain boundaries, i.e., the main reason of electron scattering, are removed.

The thickness of the single-crystalline copper thin film formed in the present invention may be adjusted in a range of 10 to 90 nm, and within this range, sufficient ballistic transport characteristics may be implemented without loss of phase of electrons.

Double-side polished sapphire (Al₂O₃) is used as the substrate, and the deposition process is performed under the conditions such as a vacuum of 2×10⁻⁷ Torr, a working pressure of 5.4×10⁻³ Torr, an RF power of 30 W, and a substrate temperature of approximately 170°C.

After forming a pattern of nanometer wide (e.g., 50 to 150 nm wide) on the single-crystalline copper thin film using electron beam lithography (e-beam lithography), a conduction path is defined through an argon (Ar) ion milling process. The conduction path is formed by etching to completely penetrate the thin film to form a channel structure through which electrons may flow directly without scattering. The nanostructured conduction path functions as a key structure element that induces quantum ballistic transport phenomena, rather than classical diffusive conduction.

As the nanodevice of the present invention has a structure that minimizes electron scattering and power loss, it may be applied to interconnect between metals in a semiconductor chip and low-loss signal transmission circuits, even to quantum devices operating at a low temperature. In particular, the problems of electron scattering, electromigration, and Joule heating that occur in conventional polycrystalline metal wiring can be effectively suppressed through the structure of the present invention, and this functions as an important technical basis for designing next-generation high-density integrated circuits and implementing quantum information devices.

Thin film formation through the ASE method is performed under the conditions such as a vacuum of 1×10⁻⁷ to 3×10⁻⁷ Torr, a working pressure of 5.0×10⁻³ to 6.0×10⁻³ Torr (approximately 5.4×10⁻³ Torr), a substrate temperature of 165 to 175°C (approximately 170°C), and an RF power of 30 W, and this is optimized to maintenance of high crystallinity. The e-beam lithography and ion etching process thereafter are core steps required to reproducibly implement a conduction path having a line width of 250 nm or smaller, and formation of the lithography pattern and process variables such as the alignment error, etching depth, and the like are directly related to the electrical characteristics of the device.

The ASE process is performed in an ultra-high vacuum environment of 1×10⁻⁷ to 3×10⁻⁷ Torr, and this vacuum level range is essential for preventing adsorption of impurities and securing high crystallinity.

The width of the nanostructured conduction path defined through the electron beam lithography is in a range of about 250 nm or smaller, and this is set in a range shorter than the mean free path of electrons and satisfies the ballistic transport conditions.

### 2. Method for manufacturing nanodevice based on single-crystalline copper thin film

The present invention relates to a method for manufacturing a nanodevice that minimizes electron scattering and exhibits negative bend resistance on the basis of a single-crystalline copper (Cu) thin film of high crystallinity. Specifically, the method includes a series of processes of growing a single-crystalline copper thin film with removed grain boundaries on a sapphire substrate using an atomic sputtering epitaxy (ASE) method, forming a nanostructured conduction path through electron beam lithography and an argon ion etching process, completing the device by depositing electrodes on both ends, and verifying performance of the device by evaluating electrical responses in a low temperature environment.

A double-side polished sapphire (Al₂O₃) substrate aligned in the (0001) direction is used as the substrate. A single-crystalline copper thin film is grown on the substrate by performing an ASE process.

The ASE process is performed under the conditions such as a vacuum of 2×10⁻⁷ Torr, a working pressure of approximately 5.4×10⁻³ Torr, a substrate temperature of approximately 170°C, and an RF power of approximately 30 W, and copper atoms deposited using high-energy ions are epitaxially aligned on the surface of the substrate.

The copper thin film formed in this process has a high-quality single-crystalline structure aligned in the (111) plane direction, in which grain boundaries are not formed, and only twin boundaries exist. The thickness of the thin film is generally in a range of 10 to 90 nm, and this affects the depth of etching and moving distance of electrons in the subsequent processes.

After the single-crystalline copper film is formed, a pattern of nanostructured conduction path having a width of 250 nm or smaller is defined through electron beam lithography. This pattern is formed using a PMMA photoresist film, and the resolution may be adjusted to tens of nanometers.

Thereafter, argon (Ar) ion etching is performed based on the defined pattern. At this point, the ion beam is controlled to completely penetrate and remove the thin film. Therefore, the conduction path formed inside the copper film functions as a passageway that allows horizontal ballistic transport of electrons without being disconnected from the lower structure.

Gold (Au) electrodes are formed at both ends of the formed conduction path in a vacuum deposition method. The electrodes are designed to minimize contact resistance with the device, and a patterning process is performed in parallel to be precisely aligned with the conduction path.

The completed structure includes nano-conduction channels within the single-crystalline copper film, and the entire device may also be implemented as a multi-channel structure including one to ten channels.

The manufactured device measures current-voltage (I-V) characteristics in a low temperature environment of 85 K or lower, and at this point, negative bend resistance is observed. This is a representative quantum transport phenomenon that occurs when electrons flow along the conduction path shorter than the mean free path without scattering.

The device may be applied as interconnect between metals within a semiconductor chip or a component of a quantum device operating at a low temperature. In particular, owing to the structural characteristics of suppressing electron scattering, it may provide a low loss, low heat generation, and high reliability compared to those of conventional metal wiring.

Hereinafter, the present invention will be described in more detail through comparative examples and experimental examples of the devices manufactured using conventional methods. The objectives, features, and advantages of the present invention will be readily understood through the embodiments described below. The present invention is not limited to the embodiments described herein and may be embodied in other forms. The embodiments introduced herein are provided to sufficiently convey the spirit of the present invention to those skilled in the art. Therefore, the present invention should not be limited by the embodiments described below.

### Embodiment 1: Formation of single-crystalline copper (Cu) thin film

A sapphire (Al₂O₃) (0001) substrate is cleaned in an ultrasonic cleaner using acetone, IPA, and DIW for 10 minutes each, and then dried by heat at 120°C for 10 minutes. Thereafter, the prepared substrate is mounted in the chamber of atomic sputtering epitaxy (ASE) equipment, and sputtering is performed using a copper target under the conditions such as a base vacuum of approximately 2×10⁻⁷ Torr, a working pressure of approximately 5.4×10⁻³ Torr, a substrate temperature of 170°C, and an RF power of 30 W.

The deposition time is set to approximately 30 minutes, and therefore, a single-crystalline copper thin film with a thickness of approximately 70 nm is grown. The crystalline-structure of the thin film is confirmed to be a single-crystalline structure aligned in the (111) plane direction through X-ray diffraction (XRD) and electron backscatter diffraction (EBSD) analyses, and grain boundaries, other than twin boundaries, are not observed.

### Embodiment 2: Patterning of nanostructured conduction path

A PMMA (950k, A4) photosensitive film is deposited on the formed single-crystalline copper thin film by spin-coating at a thickness of approximately 100 nm, and soft-baked at 180°C for 90 seconds.

A pattern of nanostructured conduction path having a width of approximately 100 nm and a length of 2 µm is defined using electron beam lithography equipment (Vistec EBPG 5200). After exposure, the photoresist film is developed in a MIBK:IPA (1:3) developer for 60 seconds.

### Embodiment 3: Formation of channel through argon ion etching

Argon (Ar) ion beam etching is performed using the developed pattern as a mask. It is set to etch to penetrate the copper film by adjusting the ion acceleration voltage to 300 eV and the etching time to approximately 80 seconds. As a result, a non-penetrating nanochannel structure is formed.

### Embodiment 4: Formation of electrode and completion of device

Cr/Au (5 nm/50 nm) metal electrodes are deposited at both ends of the conduction path in a vacuum thermal evaporation method, and then patterned using a lift-off process. The distance between the electrodes is set to approximately 2 µm.

### Experimental example 1: Ballistic transport in single-crystalline Cu(111) thin films (SCCF)

Devices of a Hall bar form having various channel widths (W) of 10 µm, 1 µm, 250 nm, and 150 nm are manufactured using standard electron beam lithography and an argon ion etching process, and the thickness (t) is approximately 90 nm (FIG. 1a, b). The cross-sectional TEM image of the device shows a perfectly aligned copper atomic array at intervals of 2.07 Å along the [111] direction of the film (FIG. 1b), and this shows that high crystal quality of the film is maintained even after the patterning process.

The bend resistance (R_{B} = V_{B} / I) is measured in the crossbar structure (FIG. 1c), and here, the current (I) is applied from terminal 1 to terminal 5, and bending voltage (V_{B}) is measured between terminal 3 and terminal 4. In the diffusive transport region, where the mean free path I_{mfp} of electrons is shorter than the device size, the bend resistance R_{B} may be expressed as the van der Pauw equation (R_{B} = (ρIn2)/(tπ)) in a symmetric crossing structure. In the diffusive transport region, R_{B} is expected to be a positive value due to the unique positive resistivity (ρ) of the material. Temperature dependency of ρ in a diffusive metal is mainly governed by the electron-acoustic phonon scattering, and this follows the Bloch-Gruneisen equation (Equation 1) derived from the Boltzmann transport theory.$ρ \left(T\right) = {ρ}_{0} + {α}_{el - ph} {\left(\frac{T}{{Θ}_{R}}\right)}^{5} {\int }_{0}^{{Θ}_{R} / T} \frac{{x}^{5}}{\left({e}^{x}-1\right) \left(1-{e}^{- x}\right)} dx$

Here, ρ₀ represents residual resistance due to defects without regard to the temperature, such as GBs, impurities, and the like, αₑₗ₋ₚₕ represents electron-phonon coupling strength, and Θ_{R} represents a Debye temperature.

As shown in FIG. 1d, temperature dependency of R_{B} in the devices of W = 10 µm and 1 µm matches well with Equation 1, and parameters suitable at this point are αₑₗ₋ₚₕ = 8.8×10⁻⁸ and Θ_{R} = 270 K. This implies that the diffusive transport dominates throughout the entire temperature range. In reality, the mean free path I_{mfp} may be calculated, through the equation shown below, from the resistivity (ρ) calculated using R_{B} obtained through the van der Pauw equation.${l}_{mfp} = \frac{m * vf}{{ne}^{2} ρ}$

In the case of a device with W = 10 µm, I_{mfp} is calculated to be 170 nm at T = 1.7 K, and this is shorter than the width of the device.

However, in the device with W ≤ 250 nm, a clear difference is observed between the R_{B}(T) predicted by the Bloch-Gruneisen equation and an actually measured value. In particular, a device with W = 150 nm exhibits a negative R_{B} value at a temperature of 90 K or lower. Although the negative bend resistance that is contrary to intuition has been observed in high-mobility two-dimensional electron systems such as a GaAs/AlGaAs heterojunction structure and graphene, observation of negative bend resistance in metal thin films has not been reported.

In the ballistic transport region, electrons injected from terminal 5 may move directly to terminal 3 without scattering (see the red arrow in FIG. 1c), and as the electrons are accumulated and a negative potential is formed around terminal 3, R_{B} decreases and eventually has a negative value.

Through the result like this, it is confirmed that the ballistic transport characteristics within the SCCF, which are previously hidden due to electron scattering by GBs, are revealed when the GBs are completely removed.

Experimental example 2: Structural defects of single-SCCF and polycrystalline Cu thin film (PCCF)

The crystallographic microstructure of the single-crystalline Cu(111) thin film (SCCF) is analyzed to confirm high crystallinity essential for ballistic transport. In the thin film growth process, grain boundaries (GBs) and twin boundaries (TBs) are formed due to lattice mismatch with the substrate. Although formation of the TBs is unavoidable, formation of the GBs can be minimized when a growth technique considering extended atomic distance mismatch (EADM) is used.

Distribution of GBs and TBs in a PCCF (FIGS. 2a, b, c), a SCCF including some GBs (FIGS. 2d, e, f), and a SCCF without GBs (FIGS. 2g, h, i) is investigated using three analysis methods described below.
- Misorientation line mapping
- Electron backscatter diffraction (EBSD)
- Scanning electron microscope (SEM) analysis

In FIG. 2, GBs and TBs are represented by blue and red lines, respectively. A PCCF generally has many grains, and both GBs and TBs exist therein. A typical 2-inch PCCF wafer contains trillions (10¹²) of grains (FIG. 2a), and each crystal has a different orientation.

The Cu film grown in the ASE method is almost perfectly aligned with respect to the (111) plane (FIG. 2e), and may include some GBs (FIG. 2d). However, as the GBs observed in the misorientation line map in FIG. 2d deviate only 1 to 2° from the ideal TB condition (60° rotation), they are not detected as grains different from each other in EBSD. Nevertheless, as these GBs may affect electron transport, only SCCFs that do not have any GBs are used in this study.

A normally grown SCCF (FIG. 2g) does not have GBs, and includes only TBs. As shown in FIG. 2i, the crystal orientation is divided into only two types of I and II, and these crystal orientations follow stacking structures such as ABC... and ACB..., respectively, and have a 60° rotational symmetry relationship around the (111) axis.

Although TB density may vary somewhat according to the location, the overall density maintains a predetermined level. TBs almost do not affect the electrical resistance, and the reasons as described below.
- As charge defects are not formed around the TBs, the potential almost does not change.
- As the grains on both sides of the TBs match well with the Fermi plane of Cu according to rotation of 60°, scattering of incident electromagnetic waves is suppressed.

In conclusion, it is theoretically and experimentally confirmed that GBs are completely removed from the SCCF used in this study and presence of TBs does not significantly affect the characteristics of electron transport.

### Experimental example 3: Electrical transport characteristics according to grain boundaries (GBs)

FIG. 3 shows the electrical transport behavior according to the GB length L_{GB}, which is the total length of the line segments separating grains, in a misorientation line map with an area of 7.7 µm × 22.7 µm measured in the EBSD technique. Generally, as GBs act as an electron scattering point, the resistivity increases as the number of GBs increases. Therefore, as the grain size (d) decreases, i.e., as the L_{GB} increases, contribution to resistance by GBs increases. Mayadas and Shatzkes (MS) have studied a more quantitative model that explains electron scattering at GBs. According to the MS model, as shown in Equation 3, the resistivity decreases as the grain size (d) increases, and the resistivity increases as the electron scattering probability (S) at the GBs increases. According to the present invention, ballistic transport characteristics can be realized in a low temperature environment by implementing a structure capable of suppressing electron scattering and preserving the phase of electrons on the basis of a single-crystalline copper (Cu) (111) thin film with removed grain boundaries. In particular, it is experimentally confirmed that negative bend resistance is exhibited through a precise nanodevice structure with a channel width of 150 nm or smaller, and this means that a moving path without scattering of electrons is secured. In addition, as the manufacturing process of combining the ASE growth method with the electron beam lithography and ion etching process allows stable formation of high-quality single-crystalline thin films and fabrication of highly reproducible nanodevices, there is provided a technical basis that can be utilized in various applications such as quantum devices, high-speed switching elements, and the like.$\frac{{ρ}_{g}}{{ρ}_{i}} = {\left\{3\left[\frac{1}{3}-\frac{1}{2}α+{α}^{2}-{α}^{3} ln \left(1+\frac{1}{α}\right)\right]\right\}}^{- 1}$$α = \frac{{l}_{mfp}}{d} \frac{S}{1 - S}$

Here, ρ_{g} represents resistivity due to electron scattering at GBs, and ρᵢ represents resistivity due to other reasons such as acoustic phonons, impurities, GBs, and the like. As shown in FIG. 3a, the resistivity of a device with W = 1 µm at 4.3 K is in the diffusive transport region, and this satisfies the relationship d∝(L_{GB})⁻¹ in a two-dimensional system and matches well with the MS theory. FIG. 3b shows the L_{GB} dependency of the normalized R_{B} at 4.3 K on the basis of the value at 285 K in the device with W = 150 nm. As the device with W = 1 µm is in the diffusive transport region at all L_{GB} values, the normalized R_{B} also shows L_{GB} dependency similar to that of the resistivity. However, in the devices with W = 250 nm and 150 nm, when L_{GB} decreases and thus I_{mfp} is longer than W, R_{B} has a negative value, and the MS model may not explain this phenomenon.

### Experimental example 4: Geometrical effect in transport measurements of SCCF

To study the ballistic transport behavior under the magnetic field in more detail, magnetic-field dependency of the bend resistance R_{B} is investigated (FIG. 4). R_{B} is symmetrized to reduce signal mixing due to subtle asymmetry and misalignment between contacts. Magnetic field B is vertically applied to the SCCF, which is parallel to the (111) direction. As the magnitude of |B| increases, electrons are bent by the Lorentz force, and the number of electrons reaching terminal 3 on the opposite side is reduced, and therefore, the symmetrized bend resistance R_{B}^{S} gradually increases (FIG. 4a). This ballistic transport phenomenon may be qualitatively explained using the Landauer-Buttiker approach.

R_{B}^{S} may be expressed in terms of forward transmission probability P_{FW}, left-turn transmission probability P_{L}, and right-turn transmission probability P_{R}, as shown in Equation 4.${R}_{B}^{S} = \frac{h}{{e}^{2}} \frac{{P}_{L} {P}_{R} - {P}_{FW}^{2}}{D}$$D = \left({P}_{L}+{P}_{R}\right) \left[2{P}_{FW}\left({P}_{FW}+{P}_{L}+{P}_{R}\right)+{P}_{L}^{2}+{P}_{R}^{2}\right]$

Since P_{FW} is much larger than P_{L} and P_{R} when there is no magnetic field (B = 0), (P_{L}P_{R} - P_{FW}²) becomes negative, and R_{B}^{S} < 0. When a magnetic field is applied, the trajectory of electrons is bent by the Lorentz force, and as P_{FW} decreases and P_{L} or P_{R} increases, and therefore, R_{B}^{S} increases. As shown in FIG. 4b, increase of R_{B}^{S} according to the magnetic field is more remarkable in the ballistic transport region (W = 150 nm) than in the diffusive transport region (W = 1 µm). This is since the electron trajectory is more clearly defined in the ballistic region.

Although anti-symmetrized Hall resistance ρxy^{as} increases linearly according to the magnetic field at 120 K like a general metal film (FIG. 4d), the Hall resistance becomes nonlinear at 1.7 K (FIG. 4e), and the slope decreases as the width of the device increases. The difference according to the temperature may be due to the change in the Fermi surface topology generated by the shift of chemical potential according to the change in the temperature. In recent studies, it has been suggested that the nonlinear Hall effect in SCCF(111) is due to hole-carrier-dominant transport confirmed through two-carrier model fitting analysis.

The nonlinear Hall effect observed in samples with W = 10 µm and 1 µm at 1.7 K corresponds to the results of previous studies, which show that both electrons and holes exist in the film with a thickness of 205 nm or smaller, i.e., in the SCCF without GBs. In the device of this width, electrons may behave without being isolated owing to the pattern size of micrometer scale although the thickness of the thin film is 90 nm. However, when the width is reduced to 250 nm or smaller, the Hall effect changes back to linear (FIG. 4e), and this shows that carriers are switched to electron-orientation.

To explain the phenomenon of the Hall effect returning to linearity, the effective band structures of a 2D Cu(111) thin film (FIG. 4d) and a 1D Cu(111) rod (FIG. 4e) are calculated and compared at a specific k-point. Although electron and hole orbits are clearly distinguished in the band structure of the 2D thin film, the band structure of the 1D structure is much more complex due to the quantum confinement effect in both the vertical and plane directions.

The Fermi surface of the 2D thin film shows a quantum-confined band along the [111] direction (FIG. 4d, left panel), and the hole band is shown to be dominant in the Fermi surface shown in the periodic zone scheme (FIG. 4d, right panel). On the contrary, the Fermi surface of the 1D structure almost does not have a noticeable structure and is difficult to provide physical insight. To overcome this problem, an effective Fermi surface is calculated by band-unfolding the 1D structure into the 2D structure (FIG. 4e, left panel). In the unfolded periodic zone scheme, it is shown that the hole band is significantly reduced and the electron orbits are dominant (FIG. 4e, right panel). Although the calculated system size is smaller than that of an actual device, it clearly shows the tendency that the hole orbits decrease as the system geometry approaches 1D.

The result of the calculation qualitatively explains the phenomenon in which the nonlinear Hall effect (NHE) based on an experimentally observed two-carrier model is switched to the linear Hall effect as the device width W decreases.

In the present invention, ballistic electron transport is observed in nanodevices based on a Cu(111) thin film, and how the transport characteristics depend on the quality of the film is investigated. A device of Hall bar shape is manufactured using an atomically flat 90 nm thick single-crystalline Cu(111) thin-film (SCCF), and negative bend resistance, which is the direct evidence of ballistic transport, is observed. Under the vertical magnetic field, the bend resistance is increased as the ballistic electrons are disturbed. In addition, distribution of grain boundaries (GBs) and twin boundaries (TBs) within the sample is analyzed through EBSD measurements, and this shows that resistance of Cu thin-film devices is mainly determined by GBs and insensitive to TBs. Furthermore, through the experimental observation and theoretical analysis, it is confirmed that Hall orbits observed in two dimensions disappear as the Cu(111) film is changed from two-dimensional to one-dimensional boundaries, and this implies that the nonlinear Hall effect demonstrated by dual carriers is changed to the linear Hall effect.

These findings provide a new platform for studying the intrinsic quantum mechanical characteristics of Cu, as well as implications important to development of high-performance electronic devices and spintronic devices by preserving quantum information such as momentum, quantum phase, spin, and the like. Furthermore, they may contribute to resolving the reliability problems in semiconductor techniques, such as Joule heating and electromigration in Cu interconnect. According to recent studies, the Fermi surface of Cu is revealed to have topologically non-trivial properties, and this is expected to open new possibilities in the experiments related to topology in ballistic metals.

According to the present invention, as a single-crystalline copper (Cu) (111) thin film with removed grain boundaries is grown in an atomic sputtering epitaxy (ASE) method, a structure of suppressing electron scattering and preserving the phase of electrons can be implemented.

In addition, as the device structure is precisely processed to have a channel width of 150 nm or smaller, characteristics of negative bend resistance may be confirmed in a low temperature environment (e.g., 1.7 K), and therefore, ballistic transport characteristics with almost no scattering in the moving path of electrons can be verified experimental.

Therefore, the present invention may drastically improve conduction efficiency compared to conventional devices based on polycrystalline metal thin film, and provide a technical basis applicable to advanced application fields such as quantum devices, high-speed switching devices, low power nanodevices, and the like.

In this way, those skilled in the art may understand that the technical configuration of the present invention described above can be implemented in other specific forms without changing the technical spirit or essential features of the present invention.

Therefore, the embodiments described above should be understood as being exemplary and not restrictive in all respects, and the scope of the present invention is indicated by the claims described below, rather than the detailed description, and all changes or modified forms derived from the meaning and scope of the claims and their equivalent concepts should be interpreted as being included in the scope of the present invention.

## Claims

1. A nanodevice having ballistic transport characteristics, the nanodevice including a single-crystalline metal thin film with removed grain boundaries, wherein the single-crystalline metal thin film is formed to suppress electron scattering, and includes conduction paths formed to have a nanometer width through electron beam lithography and an ion etching process, and the conduction path exhibits an electrical response, in which negative bend resistance occurs when electrons are transported at a low temperature.

2. The nanodevice according to claim 1, wherein the single-crystalline metal thin film is a single-crystalline copper (Cu(111)) thin film.

3. The nanodevice according to claim 1, wherein the single-crystalline metal thin film is grown through an atomic sputtering epitaxy (ASE) method.

4. The nanodevice according to claim 1, wherein the single-crystalline metal thin film has a thickness of 10 to 90 nm.

5. The nanodevice according to claim 1, wherein the conduction path is formed as a nanochannel having a line width of 250 nm or smaller.

6. The nanodevice according to claim 1, wherein the nanodevice may operate at a low temperature of 85K or lower.

7. The nanodevice according to claim 1, wherein the nanodevice measures the negative bend resistance and determines ballistic transport of electrons.

8. The nanodevice according to claim 1, wherein the nanodevice is applied to interconnect between metals of a semiconductor device or low-loss signal transmission circuits.

9. The nanodevice according to claim 2, wherein the single-crystalline metal thin film includes only twin boundaries and does not include grain boundaries.

10. The nanodevice according to claim 1, wherein the conduction path is formed through electron beam lithography and an argon (Ar) ion etching process.

11. A method for manufacturing a nanodevice based on a single-crystalline copper (Cu) thin film, the method comprising the steps of:
forming a single-crystalline copper thin film with removed grain boundaries, aligned in a (111) crystal plane direction on a sapphire (Al₂O₃) substrate, using an atomic sputtering epitaxy (ASE) method;
forming a nanometer-wide pattern by performing electron beam lithography on the single-crystalline copper thin film;
forming a conduction path by performing argon (Ar) ion etching on the basis of the pattern;
completing the nanodevice by forming electrodes at both ends of the conduction path; and
confirming whether an electrical response, in which negative bend resistance occurs when electrons are transported, is exhibited through the conduction path.

12. The method according to claim 11, wherein the single-crystalline copper thin film forms a pattern having a width of 250 nm or smaller.

13. The method according to claim 11, wherein the step of confirming whether an electrical response is exhibited includes the step of measuring the device at a temperature of 85 K or lower.

14. The method according to claim 11, wherein the single-crystalline copper thin film has a thickness of 10 to 90 nm.

15. The method according to claim 11, wherein the ASE method is performed under the condition such as a vacuum of 1×10⁻⁷ to 3×10⁻⁷ Torr.

16. The method according to claim 11, wherein the conduction path is formed to completely penetrate the thin film by argon ion etching.

17. The method according to claim 11, wherein the device is applied to interconnect between metals in a semiconductor chip or quantum devices operating at a low temperature.
